# EUROPÄISCHE PATENTSCHRIFT

(11) **EP 2 209 013 B1**
(45) Veröffentlichungstag und Bekanntmachung des Hinweises auf die Patenterteilung: **09.11.2016**
(21) Anmeldenummer: 09000635.4
(22) Anmeldetag: 17.01.2009
(51) Int. Cl.: G01R 21/00

(54) **Elektronischer Mehrphasenzähler**
Electronic multi-phase meter
Compteur multiphasique électronique

(43) Veröffentlichungstag der Anmeldung: 21.07.2010
(73) Patentinhaber: EMH metering GmbH & Co. KG, 19258 Gallin (DE)
(72) Erfinder: Hardtstock, Heiko, 21337 Lünebeburg (DE); Bal, Hakan, 22767 Hamburg (DE)
(74) Vertreter: Hauck Patentanwaltspartnerschaft mbB

(56) Entgegenhaltungen:
- EP-A- 0 299 311
- WO-A-92/15146
- DE-A1- 2 708 882
- DE-A1- 3 923 590
- GB-A- 2 421 643
- US-A- 4 359 684
- US-A- 5 973 941
- US-A1- 2005 169 020
- US-A1- 2007 096 769
- US-A1- 2009 015 234
- GRAY F M: "Meter design-factors affecting consumer safety [electricity meters]" METERING AND TARIFFS FOR ENERGY SUPPLY, EIGHTH INTERNATIONAL CONFERENC E ON (CONF. PUBL. NO. 426) BRIGHTON, UK 3-5 JULY 1996, LONDON, UK,IEE, UK, 3. Juli 1996 (1996-07-03), Seiten 199-202, XP006509153 ISBN: 978-0-85296-660-0

## Beschreibung

Die Erfindung bezieht sich auf einen elektronischen Mehrphasenzähler nach Patentanspruch 1.

Elektronische Elektrizitätszähler arbeiten mit digitalen Signalen, d.h. Strom und Spannung der zu messenden Versorgungsleistung werden digitalisiert und in einer geeigneten Prozessoreinheit verarbeitet und angezeigt. Für jede Phase ist eine Leistungsmesseinheit erforderlich, welche Strom und Spannung der Phase misst. Zur Strommessung wird ein geeigneter Stromsensor verwendet, beispielsweise ein Stromwandler oder ein Shunt. Sowohl die elektronische Leistungsmesseinheit als auch die Prozessoreinheit benötigen eine Stromversorgung. Zur Stromversorgung ist daher jeweils ein Netzteil erforderlich.

Es ist bekannt, als Netzteil für Elektrizitätszähler sogenannte Kondensatornetzteile zu verwenden. Die einfachste Schaltung eines Kondensatornetzteils besteht in einer Reihenschaltung einer Diode (oder Zenerdiode) und eines Kondensators, wobei an einem Punkt zwischen Diode (oder Zenerdiode) und Kondensator eine weitere Diode geschaltet ist und somit als Einweggleichrichter dient. Parallel zu den Versorgungsklemmen des Verbrauchers ist ein Glättungskondensator geschaltet.

Aus dem US-Patent Nr. 4,359,684 ist ein Elektrizitätszähler mit den Merkmalen des Oberbegriffs des Anspruchs 1 bekannt geworden.

Der Erfindung liegt die Aufgabe zugrunde, einen elektronischen Mehrphasenzähler zu schaffen, bei dem die Spannungsversorgung mit minimalem Aufwand erzielt wird und die Versorgung der Prozessoreinheit auch bei Ausfall einer beliebigen Phase aufrechterhalten werden kann.

Diese Aufgabe wird durch die Merkmale des Patentanspruchs 1 gelöst.

Bei dem erfindungsgemäßen Mehrphasenzähler sind die Kondensator-Netzteile über eine Gleichrichterschaltung mit den Versorgungsklemmen der Prozessoreinheit verbunden. Parallel zu den Versorgungsklemmen kann zur Spannungsstabilisierung zusätzlich und vorzugsweise eine Zenerdiode geschaltet werden. Andere Bauteile zur Spannungsstabilisierung wie z.B. ein Linearregler sind auch denkbar.

Bei der Erfindung kann auch bei Ausfall einer beliebigen Phase der Zähler weiter mit Spannung versorgt werden, ohne Schaden zu nehmen. Jedes einzelne Kondensator-Netzteil stellt einmal eine Spannung zur Versorgung der Messeinheit und einmal eine entkoppelte Spannung zur Versorgung der Prozessoreinheit zur Verfügung. Pro Phase ist daher nur ein Kondensator erforderlich. Die Spannung für die Prozessoreinheit wird über eine Gleichrichterschaltung gewonnen, vorzugsweise über eine Gleichrichterbrückenschaltung.

Nach einer Ausgestaltung der Erfindung ist eine Schutzschaltung für die Versorgungsklemmen der Leistungsmesseinheiten und die Prozessoreinheit vorgesehen.

Ausführungsbeispiele der Erfindung werden nachfolgend anhand von Zeichnungen näher erläutert.
- Fig. 1: zeigt schematisch die Spannungsversorgung eines Mehrphasenzählers nach der Erfindung.
- Fig. 2: zeigt die Schaltungsanordnung nach Fig. 1 mit Schutzschaltungen für die zu versorgenden Einheiten.

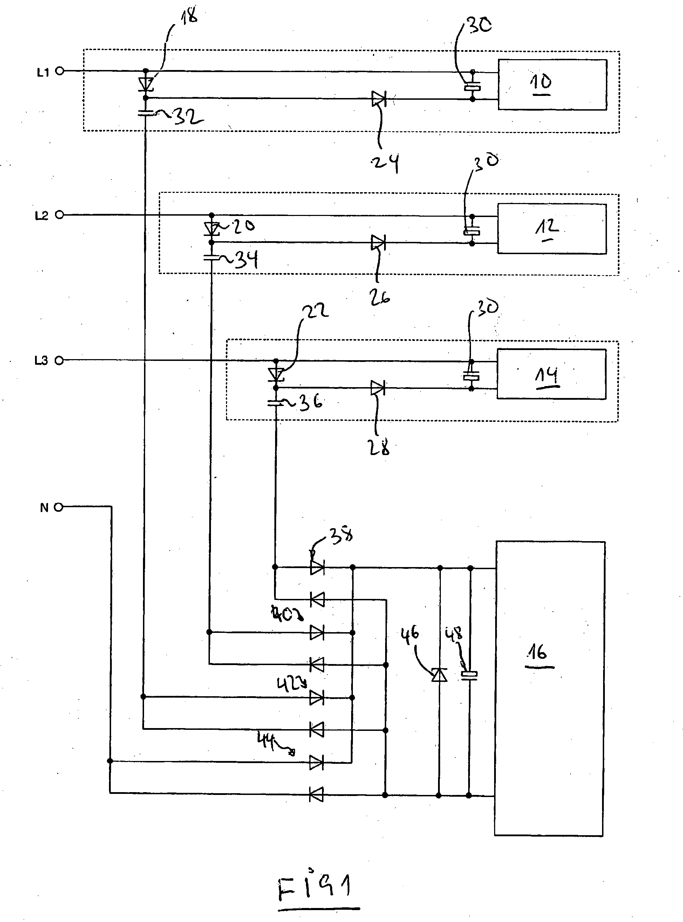

In Figur 1 sind drei Leistungsmesseinheiten 10, 12, 14 entsprechend den Phasen L1, L2, L3 vorgesehen. Einzelheiten der Messeinheiten 10 bis 14 werden nicht beschrieben, da sie allgemein bekannt sind. In Figur 1 ist ferner eine Prozessoreinheit 16 vorgesehen, welche die Ausgangssignale der Messeinheiten 10 bis 14 verarbeitet und die Ergebnisse der Verarbeitung anzeigt. Die Verbindung der Messeinheiten 10 bis 14 mit der Prozessoreinheit 16 ist fortgelassen. Die Phasen L1 bis L3 sind zum einen unmittelbar mit einer Klemme der Messeinheit 10 bis 14 verbunden und über eine Diode oder Zenerdiode 18, 20 bzw. 22 und eine Gleichrichterdiode 24, 26, 28 mit der anderen Versorgungsklemme der Messeinheit 10 bis 14 verbunden. Parallel zu den Versorgungsklemmen liegt auch ein Glättungskondensator 30.

Ein Pol der Dioden bzw. Zenerdioden 18 bis 22 ist über einen Kondensator 32, 34 bzw. 36 mit einer Gleichrichterbrückenschaltung 38 bzw. 40 bzw. 42 mit den Versorgungsklemmen der Prozessoreinheit 16 verbunden. Die Null-Leitung liegt ebenfalls über eine Gleichrichterbrückenschaltung 44 an den Versorgungsklemmen der Prozessoreinheit 16. Parallel dazu sind eine Zenerdiode 46 sowie einen Glättungskondensator 48 geschaltet.

Man erkennt, dass für die Spannungsversorgung von vier Verbrauchern nur drei Kondensatoren 32 bis 36 erforderlich sind. Die Prozessoreinheit 16 wird mit einer entkoppelten Spannung versorgt.

Bei Ausfall einer oder zwei beliebiger Phasen bzw. des Nullleiters kann der Zähler weiterhin mit Spannung versorgt werden.

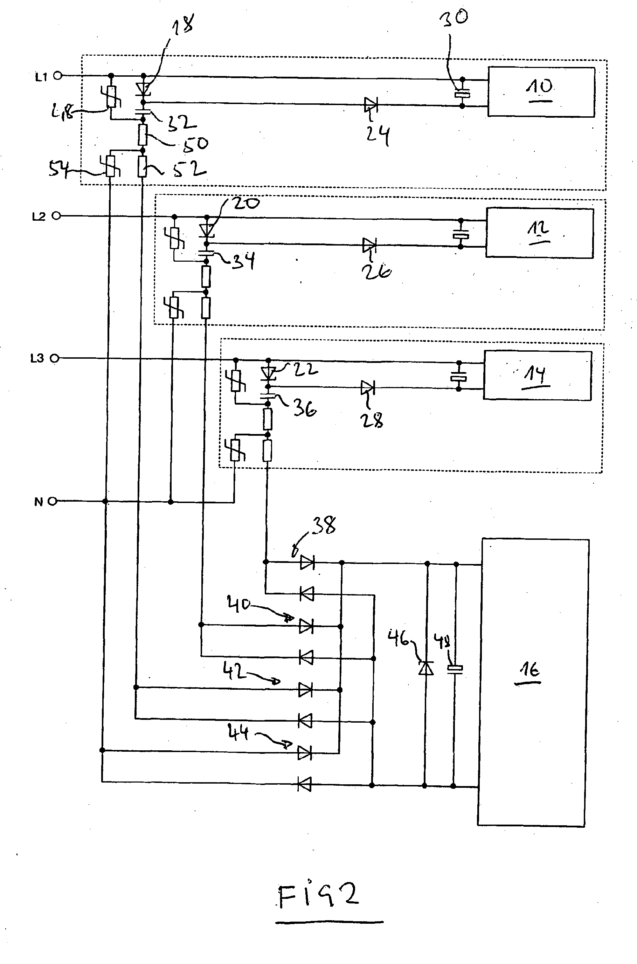

Figur 2 zeigt die Schaltungsanordnung nach Figur 1, so dass insoweit gleiche Bezugszeichen verwendet werden. Darüber hinaus ist eine Schutzschaltung vorgesehen, die jedoch lediglich bezüglich der Phase L1 näher beschrieben werden soll. Die Schutzschaltungen für die anderen Phasen sind identisch.

Parallel zur Diode bzw. Zenerdiode 18 und dem Kondensator 32 ist ein Varistor 48 geschaltet, der bekanntlich ab einer vorgegebenen Spannung niederohmig wird. In Reihe mit dem Kondensator 32 liegen zwei Widerstände 50, 52, und ein Punkt zwischen den Widerständen 50, 52 ist über einen weiteren Varistor 54 mit dem Null-Leiter N verbunden. Eine Überspannung einer Phase L1 führt daher nicht zur Beschädigung der Messeinheit 10 bzw. der Prozessoreinheit 16. Die Schutzschaltung für die Phasen L2 und L3 arbeitet in gleicher Weise, so dass auch die Messeinheiten 12, 14 gegen Überspannung geschützt sind.

## Patentansprüche

1. Elektronischer Mehrphasenzähler, z. B. Drehstromzähler, mit einer Leistungsmesseinheit je Phase, die Strom und Spannung der Phase misst, und einer Prozessoreinheit, die mit den Leistungsmesseinheiten verbunden ist, mit Anzeigemitteln und Kondensator-Netzteilen für die Leistungsmesseinheiten, **dadurch gekennzeichnet, dass** jedes der Kondensator-Netzteile zur Versorgung der Prozessoreinheit (16) über eine Gleichrichterbrückenschaltung (38, 40, 42, 44), die zwei Dioden aufweist, mit den Versorgungsklemmen der Prozessoreinheit (16) verbunden ist, so dass die Versorgung der Prozessoreinheit (16) auch bei Ausfall einer beliebigen Phase aufrecht erhalten werden kann.

2. Elektronischer Mehrphasenzähler nach Anspruch 1, **dadurch gekennzeichnet, dass** parallel zu den Versorgungsklemmen der Prozessoreinheit (16) eine Zenerdiode (46) oder ein anderes Bauteil zur Spannungsregulierung geschaltet ist.

3. Elektronischer Mehrphasenzähler nach Anspruch 1 oder 2, **dadurch gekennzeichnet, dass** eine Schutzschaltung für die Versorgungsklemmen der Leistungsmesseinheiten (10 bis 14) und die Prozessoreinheit (16) vorgesehen ist.

## Claims

1. An electronic multi-phase meter such as a three-phase current meter with a performance measuring unit per phase that measures the current and voltage of the phase, and a processing unit which is connected to the performance measuring unit, with display means and capacitor power supplies for the performance measuring units, **characterized in that** each of the capacitor power supplies for supplying the processor unit (16) is connected to two supply terminals of the processor unit (16) by means of a rectifier bridge circuit (38, 40, 42, 44) that has two diodes such that the supply of the processor unit (16) can be maintained even when any one of the phases fails.

2. The electronic multi-phase meter according to claim 1, **characterized in that** a Zener diode (46) or another component for regulating voltage is parallel-connected to the supply terminals of the processor unit (16).

3. The electronic multi-phase meter according to claim 1 or 2, **characterized in that** a protective circuit is provided for the supply terminals of the performance measuring units (10 to 14) and the processor unit (16).

## Revendications

1. Compteur polyphasé électronique, par exemple compteur à courant triphasé, avec un module de mesure de puissance par phase qui mesure le courant et la tension de la phase, et un module de processeur qui est relié aux modules de mesure de puissance, avec des moyens d'affichage et des blocs d'alimentation de condensateur pour les modules de mesure de puissance, **caractérisé en ce que** chacun des blocs d'alimentation de condensateur est relié aux bornes d'alimentation du module de processeur (16) pour l'alimentation du module de processeur (16) par le biais d'un couplage redresseur monté en pont (38, 40, 42, 44) qui présente deux diodes de sorte que l'alimentation du module de processeur (16) peut également être maintenue en cas de panne d'une phase quelconque.

2. Compteur polyphasé électronique selon la revendication 1, **caractérisé en ce qu'**une diode Zener (46) ou un autre composant pour la régulation de tension est monté parallèlement aux bornes d'alimentation du module de processeur (16).

3. Compteur polyphasé électronique selon la revendication 1 ou 2, **caractérisé en ce qu'**un circuit protecteur est prévu pour les bornes d'alimentation des modules de mesure de puissance (10 à 14) et le module de processeur (16).
